(19) **Europäisches Patentamt**

**European Patent Office**

**Office européen des brevets**

(11) **EP 1 075 027 A2**

(12) **EUROPÄISCHE PATENTANMELDUNG**

(43) Veröffentlichungstag:
   **07.02.2001 Patentblatt 2001/06**

(51) Int. Cl.7: **H01L 23/528**

(21) Anmeldenummer: **00116723.8**

(22) Anmeldetag: **02.08.2000**

(84) Benannte Vertragsstaaten:
   **AT BE CH CY DE DK ES FI FR GB GR IE IT LI LU MC NL PT SE**
   Benannte Erstreckungsstaaten:
   **AL LT LV MK RO SI**

(30) Priorität: **05.08.1999 DE 19936862**

(71) Anmelder:
   **Infineon Technologies AG**
   **81541 München (DE)**

(72) Erfinder:
   • **Baenisch, Andreas**
      **81737 München (DE)**
   • **Kling, Sabine**
      **81545 München (DE)**

(74) Vertreter:
   **Zedlitz, Peter, Dipl.-Inf.**
   **Patentanwalt,**
   **Postfach 22 13 17**
   **80503 München (DE)**

(54) **Kontaktierung von Metalleiterbahnen eines integrierten Halbleiterchips**

(57)   Ein integrierter Halbleiterchip weist wenigstens zwei Metalleiterbahnen (1, 2) zweier unterschiedlicher Metallisierungsebenen (11, 12) auf, die parallel zueinander angeordnet sind. Die Metalleiterbahnen (1, 2) sind über wenigstens eine elektrisch leitende Kontaktstelle (3) miteinander verbunden. Die Metalleiterbahnen (1, 2) verlaufen in einem ersten Bereich (10) je Richtung orthogonal zueinander. In einem zweiten Bereich (20), in dem sie miteinander kontaktiert sind, verlaufen sie je Richtung parallel zueinander und schiefwinklig zu den Richtungen der Metalleiterbahnen (1, 2) des ersten Bereichs (10). Mit dieser Anordnung wird, bei geringem Einfluß der Elektromigration, ein vergleichsweise geringer notwendiger Platzbedarf zur Kontaktierung von zueinander orthogonalen Metalleiterbahnen ermöglicht.

FIG 3

EP 1 075 027 A2

## Beschreibung

Die vorliegende Erfindung betrifft die Kontaktierung von Metalleiterbahnen eines integrierten Halbleiterchips, die in unterschiedlichen Metallisierungsebenen orthogonal zueinander angeordnet sind.

Ein integrierter Halbleiterchip weist in seiner Struktur im allgemeinen mehrere zueinander parallele Metallisierungsebenen auf. Die verschiedenen Metallisierungsebenen enthalten jeweils Metalleiterbahnen zur elektrischen. Verbindung unterschiedlicher Schaltungsteile der integrierten Schaltung. Die Metalleiterbahnen zweier unterschiedlicher Metallisierungsebenen sind Über Kontaktstellen miteinander verbunden, die eine elektrisch leitende Verbindung zwischen den Metalleiterbahnen herstellen.

Üblicherweise sind Layoutstrukturen eines integrierten Halbleiterchips in weiten Bereichen nach einem orthogonalen Raster ausgerichtet. Das bedeutet, daß beispielsweise die Metalleiterbahnen unterschiedlicher Metallisierungsebenen parallel oder in einem rechten Winkel zueinander verlaufen. Das Layoutdesign eines integrierten Halbleiterchips orientiert sich dabei im allgemeinen an einem rechtwinkligen Koordinatensystem, auf das die verschiedenen Herstellungsmittel im Verlauf der Fertigung eines Halbleiterbausteins zumeist abgestimmt sind. Als Folge davon sind Strukturen, die nach einem orthogonalen Raster ausgerichtet sind, im allgemeinen schneller und präziser herzustellen. Beispielsweise können dazu diagonale Strukturen lediglich stufenartig angenähert werden, was eine entsprechende Datendichte und im Einzelfall eine höhere Fertigungsdauer erfordern kann.

Werden zwei zueinander orthogonal verlaufende Metalleiterbahnen zweier verschiedener Metallisierungsebenen miteinander kontaktiert, finden vor allem aus oben genannten Gründen zumeist Kontakte Verwendung, deren Flächen ins orthogonale Raster passen. Ist beispielsweise die Kontaktfläche eines Kontakts breiter als eine der Metalleiterbahnen oder soll über mehrere Kontakte entlang der Metalleiterbahnen kontaktiert werden, so ist es notwendig, daß die zu kontaktierenden Metalleiterbahnen in einem Abschnitt entsprechend der Länge der vorzusehenden Kontaktstelle parallel zueinander verlaufen. Um an den Kontaktstellen die Materialbeschaffenheit der Metalleiterbahnen möglichst wenig durch Elektromigration zu beeinflussen, sollten zudem möglichst keine rechtwinkligen Richtungsänderungen der Metalleiterbahnen vorgesehen werden.

Bisher übliche Kontaktierungskonzepte sehen zueinander orthogonale Metalleiterbahnen vor, die sich zum Zwecke der Kontaktierung beispielsweise stufenartig an einen parallelen Verlauf annähern, wodurch ein relativ hoher Platzbedarf auf der Chipfläche besteht. Andere Kontaktierungskonzepte sehen eine Kontaktierung an anderen geeigneteren Stellen vor, was jedoch meist zusätzlichen Aufwand im Layoutdesignprozeß bedeutet.

Die Aufgabe der vorliegenden Erfindung ist es, einen Halbleiterchip mit wenigstens zwei orthogonal zueinander verlaufenden Metalleiterbahnen zweier unterschiedlicher Metallisierungsebenen anzugeben, die so miteinander kontaktiert sind, daß der dazu benötigte Platzbedarf möglichst klein und der Einfluß von Elektromigration möglichst gering ist.

Die Aufgabe wird gelöst durch einen integrierten Halbleiterchip gemäß Patentanspruch 1. Vorteilhafte Aus- und Weiterbildungen sind Gegenstand abhängiger Ansprüche.

Der integrierte Halbleiterchip weist wenigstens zwei Metalleiterbahnen zweier unterschiedlicher Metallisierungsebenen auf, die parallel zueinander angeordnet sind. Die Metalleiterbahnen sind durch eine elektrisch leitende Kontaktstelle miteinander elektrisch verbunden. Die Metalleiterbahnen verlaufen in einem ersten Bereich, in dem sie nicht über die Kontaktstelle miteinander kontaktiert sind, je Richtung orthogonal zueinander. Die Metalleiterbahnen verlaufen in einem zweiten Bereich, in dem sie über die Kontaktstelle miteinander kontaktiert sind, je Richtung parallel zueinander und schiefwinklig zu den Richtungen der Metalleiterbahnen des ersten Bereichs. Das bedeutet, daß infolge der schiefwinkligen Anordnung zum Zwecke der Kontaktierung keine rechtwinkligen Richtungsänderungen notwendig sind, die den Einfluß von Elektromigration begünstigen. Durch eine derartige Anordnung entfällt zudem die eingangs genannte Notwendigkeit der stufenweisen Annäherung, wodurch eine platzsparende Anordnung der Metalleiterbahnen ermöglicht wird.

Um den Einfluß der Elektromigration für alle Metalleiterbahnen möglichst gleichmäßig gering zu halten, ist es vorteilhaft, die Metalleiterbahnen je Richtung in einem Winkel von 45° zu den Richtungen der Metalleiterbahnen des ersten Bereichs anzuordnen.

In einer üblichen Ausführungsform weist die Kontaktstelle eine rechteckige Fläche parallel zu den Metallisierungsebenen auf. Soll das Layout der Kontaktstelle in bezug auf bisherige Kontaktierungskonzepte nicht geändert werden, so ist die Fläche der Kontaktstelle kantenparallel zu den Metalleiterbahnen des ersten Bereichs angeordnet. Dies kann jedoch im Kontaktierungsbereich eine Verbreiterung der Metalleiterbahnen erfordern, da die Kanten der Kontaktfläche und die Metalleiterbahnen schiefwinklig zueinander angeordnet sind und die Kontaktstelle dadurch eine größere Breite auf den Metalleiterbahnen beansprucht.

Um die Breite der Metalleiterbahnen nicht zu beeinflussen, ist es vorteilhaft, die Fläche der Kontaktstelle kantenparallel zu den Metalleiterbahnen des zweiten Bereichs anzuordnen.

Das bedeutet, ein Teil der Kanten der Kontaktfläche und die Kanten der Metalleiterbahnen verlaufen im Kontaktierungsbereich parallel zueinander.

Zur Verbesserung der Kontaktierung ist es günstig, die Metalleiterbahnen in dem Kontaktierungsbereich Über mehrere Kontaktstellen miteinander zu verbinden, die entlang der Metalleiterbahnen angeordnet sind. Mit der erfindungsgemäßen Anordnung der Kontaktstelle wird dadurch der benötigte Platzbedarf nicht wesentlich erhöht.

Die Erfindung ist allgemein für alle Halbleiterchips anwendbar, die eine Kontaktierung von Metalleiterbahnen zweier Metallisierungsebenen aufweisen. Mit dem Fortschritt in der Datenverarbeitung und Datenspeicherung sowie mit der Weiterentwicklung der zur Fertigung notwendigen technischen Mittel wird es zunehmend möglich, Strukturen einer integrierten Schaltung, die nicht an ein vorgegebenes orthogonales Layoutraster angepaßt sind, schneller und mit zunehmender Präzision herzustellen.

Die Erfindung wird im folgenden anhand der in der Zeichnung dargestellten Figuren näher erläutert. Es zeigen:

Figur 1    eine schematische Darstellung einer Kontaktierung zweier zueinander orthogonaler Metalleiterbahnen,

Figur 2    eine zu Figur 1 alternative Kontaktierung zweier Metalleiterbahnen,

Figur 3    eine schematische Darstellung einer erfindungsgemäßen Ausfuhrung zur Kontaktierung zweier zueinander orthogonaler Metalleiterbahnen,

Figur 4    einen schematischen Querschnitt einer Kontaktstelle,

Figur 5    zwei zueinander alternative Anordnungen einer Kontaktstelle.

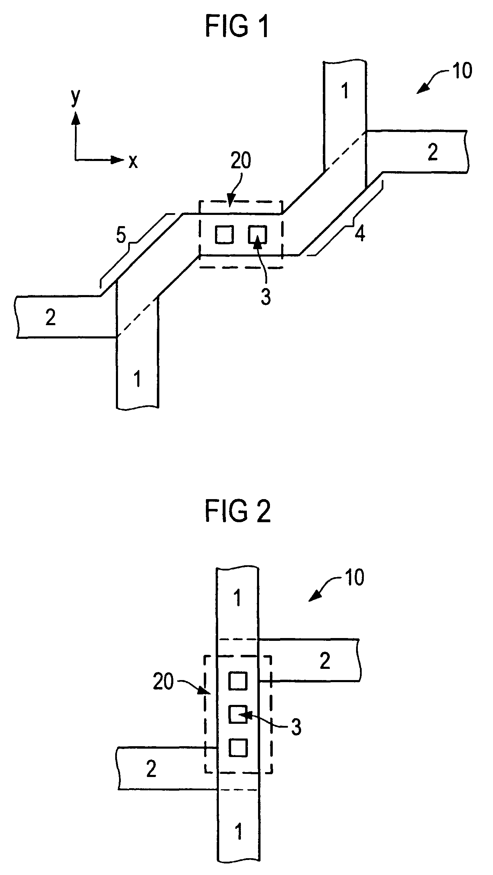

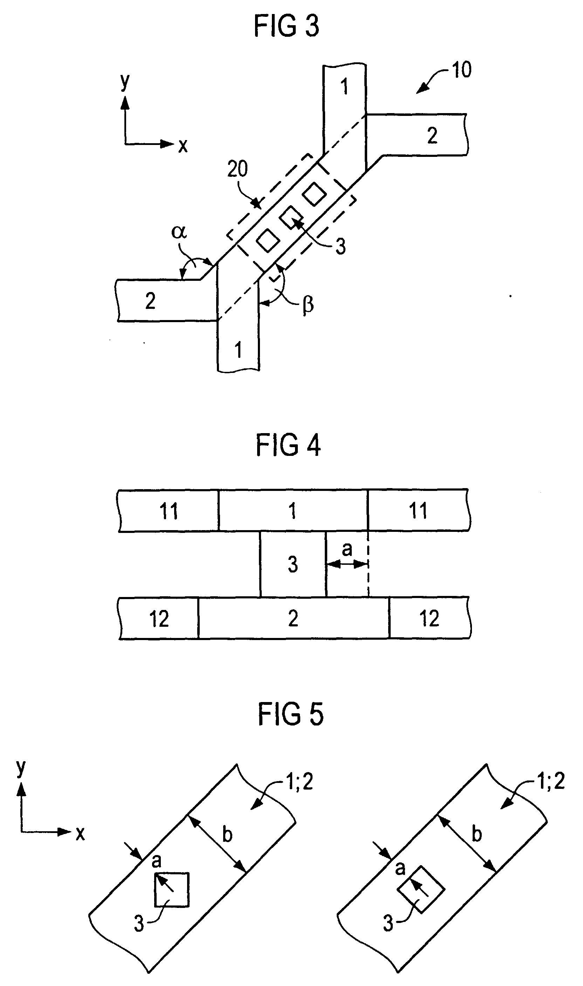

Figur 1 zeigt eine Metalleiterbahn 1 einer ersten Metallisierungsebene und eine Metalleiterbahn 2 einer zweiten Metallisierungsebene. Die Metallisierungsebenen verlaufen parallel zueinander (siehe Figur 4), was in der Draufsicht nach Figur 1 nicht erkennbar ist. Die Metalleiterbahnen 1 und 2, die bandförmig ausgeführt sind, sind in einem ersten Bereich 10 nicht über eine Kontaktstelle miteinander kontaktiert. Sie verlaufen gemäß einem rechtwinkligen Koordinatensystem in Y- bzw. X-Richtung orthogonal zueinander. In einem zweiten Bereich 20 sind die Metalleiterbahnen 1 und 2 über die Kontaktstellen 3 miteinander elektrisch kontaktiert. Der Bereich 20 bzw. die Kontaktstellen 3 sind ebenfalls gemäß dem rechtwinkligen Koordinatensystem ausgerichtet. Zur Vermeidung von rechtwinkligen Richtungsänderungen und des damit verbundenen Einflusses der Elektromigration weisen die Metalleiterbahnen 1 und 2 die diagonalen Abschnitte 4 und 5 auf. Eine solche stufenartige Annäherung der Metalleiterbahnen 1 und 2 an den Kontaktierungsbereich 20 erfordert je nach Ausführung einen relativ hohen Platzbedarf, vor allem in X-Richtung, aber auch in Y-Richtung.

In Figur 2 ist eine zur Figur 1 alternative Kontaktierung der Metalleiterbahnen 1 und 2 gezeigt. In diesem Beispiel wird kein zusätzlicher Platzbedarf für den Kontaktierungsbereich 20 in X-Richtung benötigt. Jedoch nimmt, insbesondere an den Randbereichen des Kontaktierungsbereichs 20, der Einfluß der Elektromigration zu. Dies ist bedingt durch die vergleichsweise hohen Stromdichten an den Stellen der Metalleiterbahn 2, an denen diese ihren Verlauf in rechtwinkliger Richtung verändert. Diese hohen Stromdichten können zu Veränderungen der Materialeigenschaften des Metalls führen, wodurch beispielsweise die Zuverlässigkeit und die Lebensdauer der Metalleiterbahn 2 nachteilig beeinflußt werden kann.

Figur 3 zeigt eine schematische Darstellung einer erfindungsgemäßen Ausführung zur Kontaktierung der Metalleiterbahnen 1 und 2. Diese sind in dem Kontaktierungsbereich 20, in dem sie über die Kontaktstellen 3 miteinander kontaktiert sind, je Richtung parallel zueinander und schiefwinklig zu den Richtungen der Metalleiterbahnen 1 und 2 des Bereichs 10 angeordnet. Im Vergleich zu der Anordnung nach Figur 1 ist der zusätzliche Platzbedarf zur Kontaktierung vor allem in X-Richtung deutlich reduziert. Durch die Vermeidung von rechtwinkligen Richtungsänderungen der Metalleiterbahnen ist außerdem der Einfluß der Elektromigration reduziert. Um diesen Einfluß für beide Metalleiterbahnen 1 und 2 gleichmäßig gering zu halten, ist eine Anordnung des Kontaktierungsbereichs 20 in einem Winkel $\alpha = \beta$ von 45° zu den Richtungen der Metalleiterbahnen 1 und 2 des Bereichs 10 vorteilhaft.

In Figur 4 ist ein schematischer Querschnitt einer Kontaktstelle 3 im Kontaktierungsbereich 20 dargestellt. Man erkennt die Metalleiterbahn 1 einer ersten Metallisierungsebene 11 und die Metalleiterbahn 2 einer zweiten Metallisierungsebene 12. Die Metallisierungsebenen 11 und 12 sind parallel zueinander angeordnet. Eine elektrisch leitende Kontaktstelle 3, die eine rechteckige Fläche parallel zu den Metallisierungsebenen 11 und 12 aufweist, ist zwischen den Metalleiterbahnen 1 und 2 angeordnet. Um beispielsweise einen etwaigen bei der Herstellung auftretenden Versatz bei der Zentrierung oder Linienführung der Kontaktstelle 3 in einem gewissen Maß ausgleichen zu können, ist üblicherweise eine Überlappung a zwischen der äußersten Begrenzung der Kontaktstelle 3 und beispielsweise der Metalleiterbahn 1 vorgesehen.

Figur 5 zeigt zwei zueinander alternative Anordnungen einer Kontaktstelle 3. Die zueinander parallelen Metalleiterbahnen 1 und 2 sind ausschnittsweise dargestellt. Im linken Teil der Figur 5 ist die Fläche der Kontaktstelle 3 kantenparallel zu den Metalleiterbahnen des Bereichs 10 angeordnet. Die Überlappung a wird von der äußersten Grenze der Kontaktstelle 3 aus in Richtung Leiterbahnbegrenzung bemessen (kürzester Abstand zwischen Kontaktstelle 3 und Kante der Leiterbahn). Daraus ergibt sich die erforderliche Breite b der Metalleiterbahnen im Kontaktierungsbereich. Im rechten Teil der Figur 5 ist die Fläche der Kontaktstelle 3 kantenparallel zu den Metalleiterbahnen 1 und 2 des Kontaktierungsbereichs 20 angeordnet. Die erforderliche Breite b der Metalleiterbahnen 1 und 2 ist bei gleicher Überlappung a in dieser Anordnung im Vergleich zu nebenstehender Anordnung reduziert. Die Metalleiterbahnen 1 und 2 weisen im Kontaktierungsbereich demzufolge einen verminderten Platzbedarf auf, was vor allem vorteilhaft bei mehreren nebeneinander verlaufenden Metalleiterbahnen ist. Diese können so enger aneinander plaziert werden.

**Patentansprüche**

1. Integrierter Halbleiterchip

   - mit wenigstens einer Metalleiterbahn (1) einer ersten Metallisierungsebene (11) und einer Metalleiterbahn (2) einer zweiten Metallisierungsebene (12),
   - bei dem die Metallisierungsebenen (11, 12) parallel zueinander angeordnet sind,
   - der wenigstens eine elektrisch leitende Kontaktstelle (3) zwischen den Metalleiterbahnen (1, 2) aufweist,
   - bei dein die Metalleiterbahnen (1, 2) in einem ersten Bereich (10), in dem sie nicht über die Kontaktstelle (3) miteinander kontaktiert sind, je Richtung orthogonal zueinander angeordnet sind,
   - bei dem die Metalleiterbahnen (1, 2) in einem zweiten Bereich (20), in dem sie über die Kontaktstelle (3) miteinander kontaktiert sind, je Richtung parallel zueinander und schiefwinklig zu den Richtungen der Metalleiterbahnen (1, 2) des ersten Bereichs (10) angeordnet sind.

2. Integrierter Halbleiterchip nach Anspruch 1, dadurch gekennzeichnet, daß die Metalleiterbahnen (1, 2) in dem zweiten Bereich (20) je Richtung in einem Winkel von 45° zu den Richtungen der Metalleiterbahnen (1, 2) des ersten Bereichs (10) angeordnet sind.

3. Integrierter Halbleiterchip nach einem der vorhergehenden Ansprüche, dadurch gekennzeichnet, daß die Kontaktstelle (3) eine Fläche parallel zu den Metallisierungsebenen (11, 12) aufweist, die rechteckig ist.

4. Integrierter Halbleiterchip nach Anspruch 3, dadurch gekennzeichnet, daß die Fläche der Kontaktstelle (3) kantenparallel zu den Metalleiterbahnen (1, 2) des ersten Bereichs (10) angeordnet ist.

5. Integrierter Halbleiterchip nach Anspruch 3, dadurch gekennzeichnet, daß die Fläche der Kontaktstelle (3) kantenparallel zu den Metalleiterbahnen (1, 2) des zweiten Bereichs (20) angeordnet ist.

6. Integrierter Halbleiterchip nach einem der vorhergehenden Ansprüche, dadurch gekennzeichnet, daß die Metalleiterbahnen (1, 2) in dem zweiten Bereich (20) über mehrere Kontaktstellen (3) miteinander kontaktiert sind, die entlang der Metalleiterbahnen (1, 2) angeordnet sind.

## FIG 1

y

x

20

5

4

3

2

1

10

## FIG 2

1

20

2

3

2

1

10

## FIG 3

## FIG 4

## FIG 5